# EUROPEAN PATENT SPECIFICATION

(11) **EP 3 462 533 B1**
(45) Date of publication and mention of the grant of the patent: **09.08.2023**
(21) Application number: 18196896.7
(22) Date of filing: 26.09.2018
(51) Int. Cl.: H01P 5/08, G02B 6/42, H05K 1/02

(54) **LOW-LOSS PLUG CONNECTION ARRANGEMENT AND SYSTEM HAVING AT LEAST ONE SUCH PLUG CONNECTION ARRANGEMENT**
VERLUSTARME STECKERVERBINDUNGSANORDNUNG UND SYSTEM MIT MINDESTENS EINER SOLCHEN STECKERVERBINDUNGSANORDNUNG
AGENCEMENT ET SYSTÈME DE RACCORDEMENT PAR ENFICHAGE À FAIBLES PERTES ET SYSTÈME PRÉSENTANT AU MOINS UN TEL AGENCEMENT DE RACCORDEMENT PAR ENFICHAGE

(30) Priority: 28.09.2017 DE 102017122600
(43) Date of publication of application: 03.04.2019
(73) Proprietor: TE Connectivity Germany GmbH, 64625 Bensheim (DE)
(72) Inventor: RUSCH, Christian, 67105 Schifferstadt (DE); MANDEL, Christian, 64291 Darmstadt (DE)
(74) Representative: Patentanwaltskanzlei WILHELM & BECK

(56) References cited:
- EP-A1- 2 573 951
- FR-A1- 3 022 696
- US-A- 5 600 289
- US-A1- 2012 153 969
- US-B1- 9 490 518

## Description

The invention relates to a plug connection arrangement for mechanically and electromagnetically coupling at least one radiation source to at least one dielectric waveguide, having at least one housing which can be mounted on a printed circuit board, having the at least one radiation source for generating electromagnetic waves and having at least one dielectric waveguide. Moreover, the invention relates to a system for transmitting data by electromagnetic radiation between at least two controllers.

Systems with high-frequency carrier signals can be used for future communication methods with high data transmission rates. Such high-frequency carrier signals are electromagnetic rays with a wavelength in the millimetre or micrometre range. However, radiation sources provided for this purpose have a limited available power in the frequency range limited for a data transmission. In order to be able to guarantee a data transmission, receiving units require a defined minimum signal strength.

In particular in the automobile industry, transmission lengths for electromagnetic radiation of between 10 and 15 m are required. With dielectric waveguides, the electromagnetic rays can be guided over these transmission lengths. Due to the losses inside the dielectric waveguides and in the plug connections or couplings of the dielectric waveguides, guaranteeing the defined minimum signal strength can be problematic. The dielectric waveguides must thus have as low an attenuation as possible of the transmitted electromagnetic radiation. However, the dielectric waveguides can be established with regard to a material selection, length and arrangement. Moreover, optimisations of the actuators or the radiation sources and the dielectric waveguides are often only possible with great effort.

FR 3 022 696 teaches a connector for a plastic waveguide, comprising a radiofrequency antenna.

US 9 490 518 B1 teaches a system for transmitting sub-terahertz electro-magnetic radio frequency signals using a dielectric waveguide.

US 2012/153969 A1 teaches a measuring device working with high frequency microwaves.

The problem of the invention can be seen as proposing an improved plug connection arrangement with reduced electromagnetic losses for coupling at least one radiation source with at least one dielectric waveguide.

This problem is solved by means of the respective subject-matter of the independent claim. Advantageous configurations of the invention form the subject-matter of respective dependent subclaims.

According to an aspect of the invention, a plug connection arrangement for mechanically and electromagnetically coupling at least one radiation source to a dielectric waveguide according to the independent claim. It

Further embodiments are covered by the subject-matter of the dependent claims.

By way of such an arrangement of the plug connection, a transmission length can be reduced through the dielectric waveguide. As a result of this, the transmission losses in the dielectric waveguide can be reduced. A combination of "end-fire" antennas with plug connections, arranged at edge regions of the controller housings, for receiving the dielectric waveguides enables an efficient and robust electromagnetic connection between a radiation source and the dielectric waveguide. By using receiving units, dielectric waveguides can be aligned and fixed optimally adapted to the radiation sources or radiation receivers. The system reduces a number of necessary electromagnetic couplings between an electromagnetic radiation source and a radiation receiver or between a transmitter and a receiver. It is thus possible to reduce transmission losses and guarantee a required minimum signal strength for a signal transmission in the case of constant or greater transmission lengths.

Preferred exemplary embodiments of the invention are explained hereinafter in greater detail using greatly simplified schematic depictions. In the drawings
- Fig. 1a: shows a perspective exploded depiction of a plug connection arrangement according to a first exemplary embodiment,
- Fig. 1b: shows a plan view of a plug connection arrangement according to the first exemplary embodiment,
- Fig. 2: shows sectional depictions of various arrangements of a signal source in a plug connection arrangement according to the first exemplary embodiment,
- Fig. 3: shows a perspective depiction of a plug connection arrangement according to a second exemplary embodiment, not covered by the claims,
- Fig. 4: shows sectional depictions of various arrangements of a signal source in a plug connection arrangement according to the second exemplary embodiment, not covered by the claims,
- Fig. 5: shows a perspective depiction of a plug connection arrangement according to a third exemplary embodiment, not covered by the claims,
- Fig. 6a: shows a perspective exploded depiction of a plug connection arrangement according to a fourth exemplary embodiment, not covered by the claims,
- Fig. 6b: shows a perspective depiction of a one-part connecting element of the plug connection arrangement according to the fourth exemplary embodiment, not covered by the claims,
- Fig. 7a: shows a perspective depiction of a plug connection arrangement according to a fifth exemplary embodiment, not covered by the claims,
- Fig. 7b: shows a perspective depiction of a one-part connecting element of the plug connection arrangement according to the fifth exemplary embodiment, not covered by the claims,
- Fig. 8a: shows a perspective depiction of a plug connection arrangement according to a sixth exemplary embodiment, not covered by the claims,
- Fig. 8b: shows a perspective depiction of a multi-part connecting element of the plug connection arrangement according to the sixth exemplary embodiment, not covered by the claims,
- Fig. 9: shows a schematic depiction of a system for transmitting data according to a first exemplary embodiment.

In the figures, the same structural elements each have the same reference numbers.

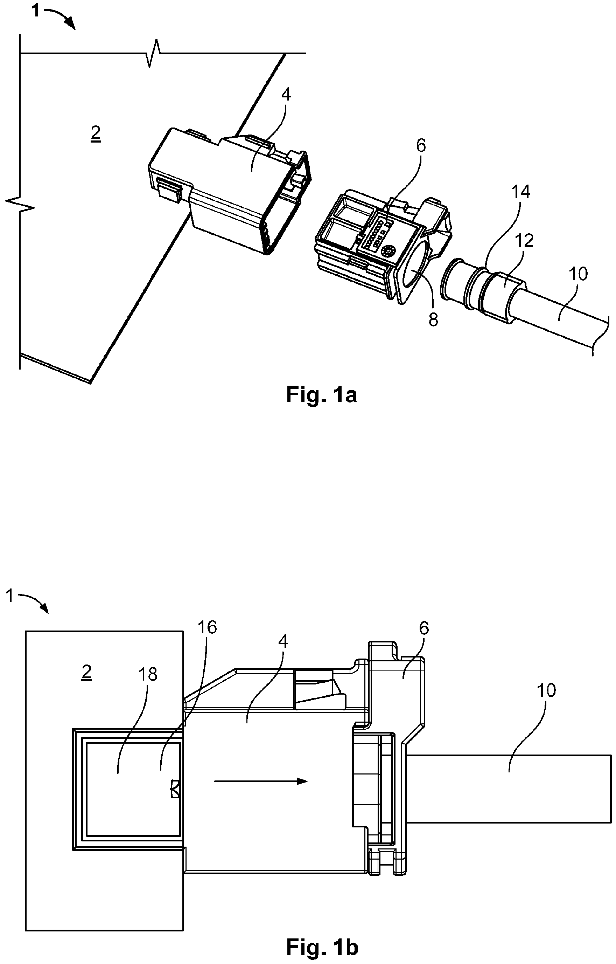

Figure 1a shows a perspective exploded depiction of a plug connection arrangement 1 according to a first exemplary embodiment. The plug connection arrangement 1 has a housing 4 arranged on a printed circuit board 2. The housing 4 is mounted on a rim of the printed circuit board 2 and projects beyond the rim of the printed circuit board 2. A receiving unit 6 can be inserted into the housing 4 in a form-fitting manner. The receiving unit 6 can engage in a releasable manner in the housing 4, according to the exemplary embodiment. The receiving unit 6 has a cylindrical opening 8 for receiving, at its end, a dielectric waveguide 10. In this case, the dielectric waveguide 10 has, at its end, a sleeve 12 with a circumferential recess 14. The waveguide 10 can be received in an engageable manner by the receiving unit 6 at a defined insertion depth by means of the recess 14. In this case, the receiving unit 6, in a state arranged in the housing 4, projects into the housing 4 such that the inserted waveguide 10 can be spaced apart at its ends with a minimal spacing from a radiation source 16 positioned in the housing 4. The waveguide 10, at its ends, advantageously does not have a spacing from the radiation source 16. The waveguide 10 is aligned parallel to a planar elongation of the printed circuit board 2 relative to the radiation source 16 by the receiving unit 6.

Figure 1b depicts a plan view of a plug connection arrangement 1 according to the first exemplary embodiment from Figure 1a. For reasons of clarity, the housing 4 is not represented in the region of the printed circuit board 2, such that an integrated switching circuit 18 and a radiation source 16 arranged on the integrated switching circuit 18 are visible. The receiving unit 6 and the waveguide 10 received by the receiving unit 6 are arranged directly adjacent to the radiation source 16 in the inserted state. As a result of this, the radiation source 16 can couple the generated electromagnetic rays into the waveguide 10. The waveguide 10 can be aligned precisely to the radiation source 16 by the receiving unit 6. According to the exemplary embodiment, the radiation source 16 is a so-called "end-fire" antenna. In particular, the radiation source can be a Vivaldi antenna, a Yagi antenna, a horn antenna or a so-called "tapered substrate integrated waveguide" antenna. The integrated switching circuit as actuator 18 of the radiation source 16 and the radiation source 16 are in this case arranged in the housing 4 and are connected in an electrically conductive manner to the printed circuit board 2 by a surface mounting of the housing 4. The arrow here illustrates a main radiation direction of the radiation source 16 or a direction of the main lobe of the radiation source 16.

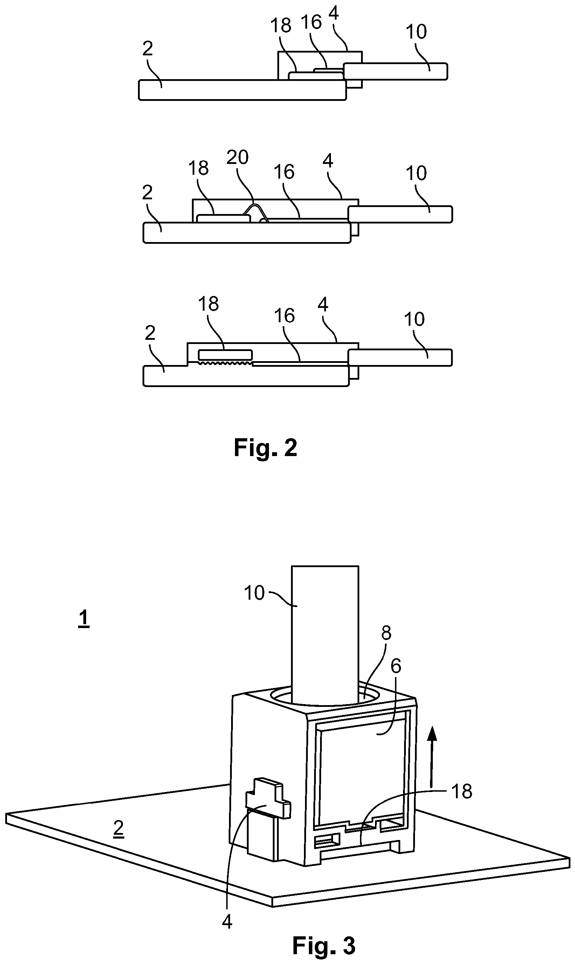

Figure 2 represents sectional depictions of various arrangements of a signal source 16 in a plug connection arrangement 1 according to the first exemplary embodiment. Some exemplary possibilities for arranging the signal source 16 and the actuator 18 of the signal source 16, and the waveguide 10 aligned corresponding to the signal source 16 are depicted. In this case, the actuator 18 can also be arranged outside of the housing 4. The signal source 16 can, for example, be arranged on the actuator 18 or an integrated circuit 18 of the actuator. In particular, the signal source 16 can also be integrated into the integrated circuit 18. As a further alternative, the at least one radiation source 16 can be imprinted onto the printed circuit board 2 or be formed on the printed circuit board 2 by removing material. The actuator 18 can be connected via one or multiple bond wires 20, for example. According to a further alternative, an actuator 18 can be applied onto at least one radiation source 16 arranged on the printed circuit board 2. In this case, the actuator 18 or an integrated circuit 18 can, for example, be soldered to the at least one radiation source 16 by a ball grid array. The various possibilities for arranging the at least one radiation source 16 and the actuator 18 can be realised depending on requirements for a necessary bandwidth and frequency of the electromagnetic radiation.

Figure 3 shows a perspective depiction of a plug connection arrangement 1 according to a second exemplary embodiment not covered by the claims. The actuator 18 of the radiation source 16 is positioned on the printed circuit board 2, in the form of an integrated circuit 18, by surface-mounting. The radiation source 16 is integrated in the actuator 18. According to the exemplary embodiment, the radiation source 16 is a so-called "broadside" antenna which has a directivity which is orthogonal to its planar elongation. The radiation source 16 can be a patch antenna or an array of patch antennas, for example. The housing 4 is positioned over the radiation source 16, in order to enclose and cover the radiation source 16, at least in sections. The housing is mechanically connected to the printed circuit board 2 and serves as a positioning aid and form-fitting receptacle for the receiving unit 6. In this case, the receiving unit 6 can be plugged and engaged vertically onto the housing 4. The receiving unit 6 has a vertically configured opening 8 for receiving and positioning the dielectric waveguide 10. The waveguide 10 is here aligned perpendicular to the planar elongation of the printed circuit board 2 by the receiving unit 6. In the aligned state, the dielectric waveguide 10 is electromagnetically coupled to the radiation source 16 and can receive and guide the generated electromagnetic radiation. The arrow illustrates the radiation direction of the radiation source 16.

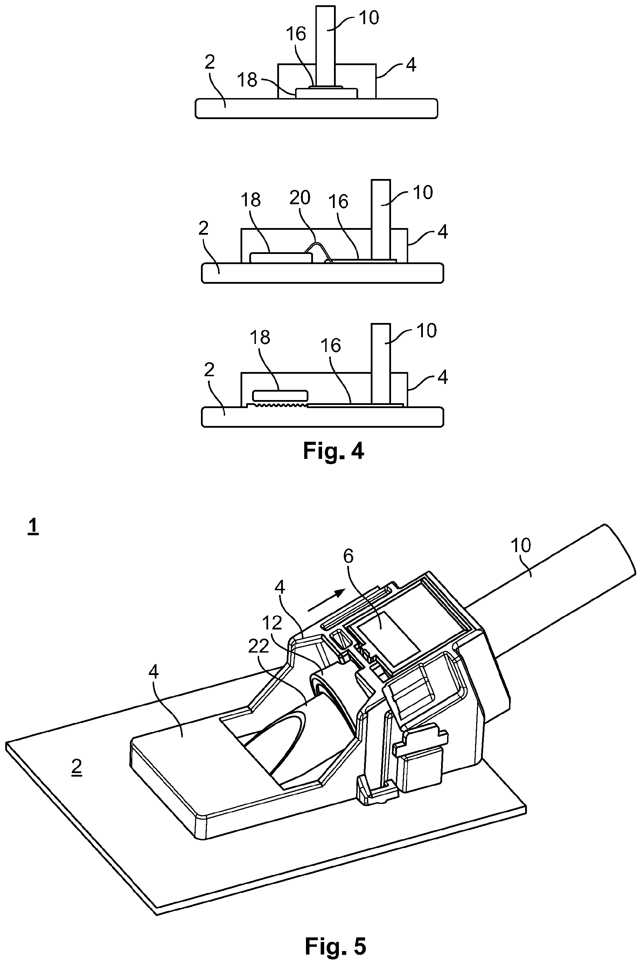

Figure 4 shows sectional depictions of various arrangements of a signal source 16 in a plug connection arrangement 1 according to the second exemplary embodiment not covered by the claims. In contrast to the arrangement possibilities shown in Figure 2, according to the second exemplary embodiment, not covered by the claims radiation sources are arranged with a radiation direction perpendicular to the 5 planar elongation of the printed circuit board 2.

Figure 5 depicts a perspective depiction of a plug connection arrangement 1 according to a third exemplary embodiment not covered by the claims. In contrast to the described exemplary embodiments, the plug connection arrangement has a radiation source 16 with a radiation direction tilted at an angle of 45° relative to the printed circuit board 2. The arrow illustrates the propagation direction of a main lobe of the radiation source. The at least one radiation source 16 can be, for example, an "endfire" antenna with a subsequent reflector, a subsequent lens or a subsequent conductor. Moreover, the at least one radiation source 16 can be a phased-array antenna made of patch antennas or dipole antennas. The receiving unit 6 is arranged in the housing 4 and can receive the dielectric waveguide 10 in an aligned manner corresponding to the radiation direction of the at least one radiation source 16. In this case, the dielectric waveguide 10 is positioned by the receiving unit 6 in an aligned manner at an angle of 45° relative to the main beam of the at least one radiation source 16. In order for the spacing between the at least one radiation source 16 and the dielectric waveguide 10 to be minimal, the dielectric waveguide 10 does not end with the end-sleeve 12, but instead projects into the housing 4 via the end-sleeve 12 with an extension section 22 up to the radiation source 16.

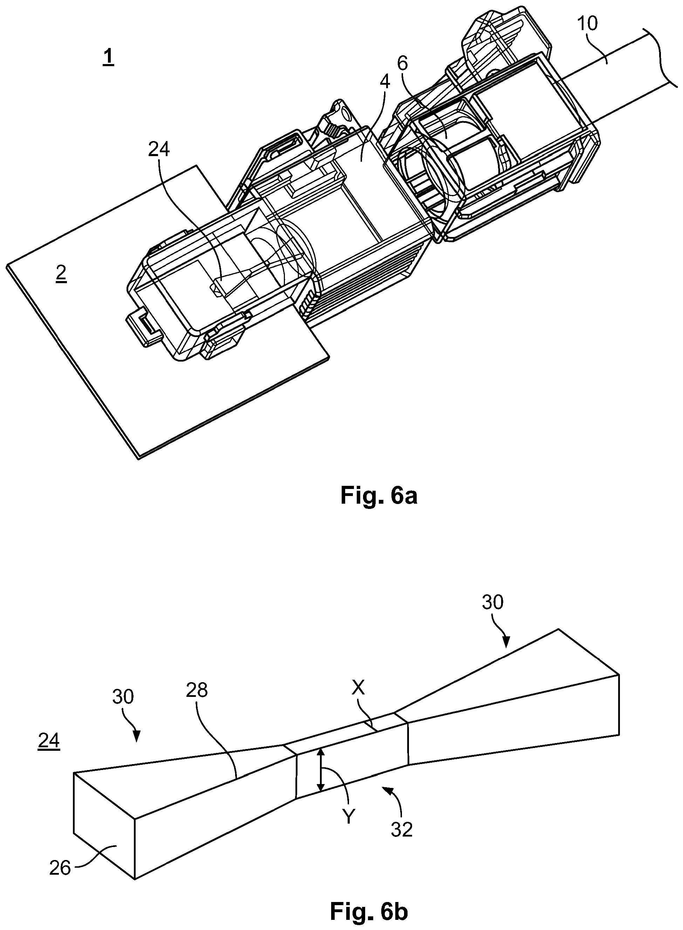

Figure 6a shows a perspective exploded depiction of a plug connection arrangement 1 according to a fourth exemplary embodiment not covered by the claims . In contrast to the plug connection arrangement 1 according to the first exemplary embodiment, the plug connection arrangement 1, according to the fourth exemplary embodiment, has a connecting element 24. The connecting element 24 here serves as a coupling between the at least one radiation source 16 and the dielectric waveguide 10. The connecting element 24 is here positioned in the housing 4 between the radiation source 16 and an end of the dielectric waveguide 10. Various spacings between the radiation source 16 and the dielectric waveguide 10 can be bridged in the inserted state by the connecting element 24. In this case, the connecting element 24 serves as a metallic waveguide. Figure 6b represents a perspective depiction of the one-part connecting element 24 of the plug connection arrangement 1 according to the fourth exemplary embodiment. The connecting element 24 is formed straight and has a rectangular cross-section. The connecting element 24 here has an inner volume 26, which is permeable for electromagnetic radiation and made of a plastics material, and a metallised outer lateral surface 28. The connecting element 24 has, at its ends, in each case a region 30 with a cross-section which is conically expanded at the end. The connecting element 24 has, between the end regions with conically expanded cross-sections 30, a central region 32 for low-loss transmission of electromagnetic rays. The central region 32 has a greater height y than a half propagation wavelength of the electromagnetic radiation and a smaller width x than the height y. As a result of this, a so-called "single-mode" propagation of the electromagnetic radiation can be realised in the central region 32.

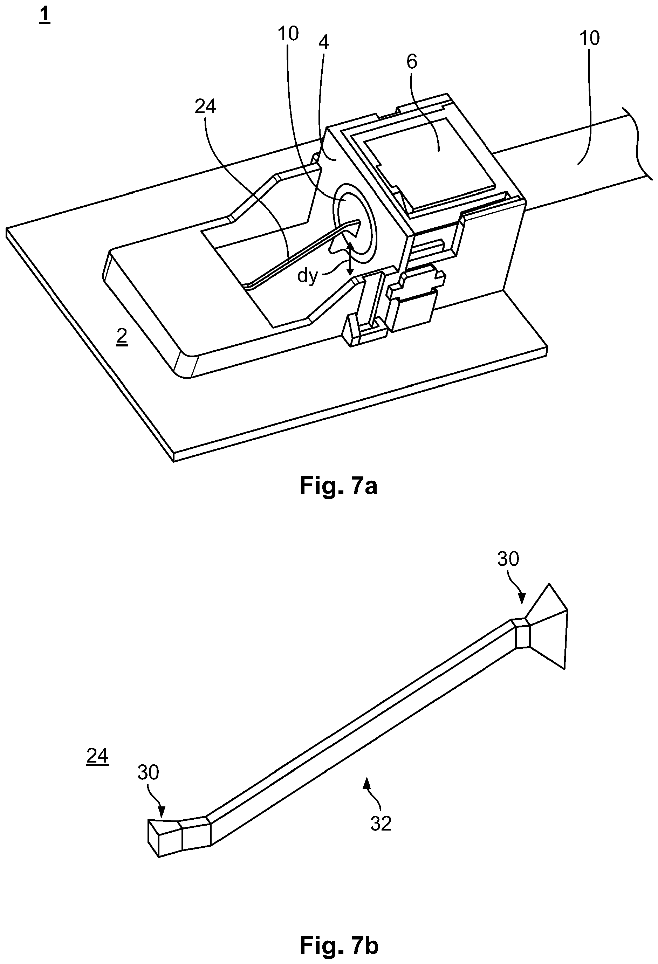

Figure 7a shows a perspective depiction of a plug connection arrangement 1 according to a fifth exemplary embodiment not covered by the claims. In contrast to the fourth exemplary embodiment, the dielectric waveguide 10 is spaced apart, at its end, from the printed circuit board 2 and thus has a height offset dy from a radiation source 16 arranged on the printed circuit board 2. The connecting element 24 is designed to be bent in the central region 32, such that the spacing between the radiation source 16 and the dielectric waveguide 10 can be bridged with low losses. In particular, the central region 32 is designed to be bent such that the electromagnetic radiation is perpendicularly and directly coupled into the connecting element 24 and subsequently can be perpendicularly coupled out of the connecting element 24 into the dielectric waveguide 10. As a result of this, the dielectric waveguide 10 can be received by the receiving unit 6 in a horizontal manner. Moreover, the dielectric waveguide 10 ends with the end-sleeve 12, as a result of which a production can be simplified and a durability of the dielectric waveguide 10 can be increased.

Figure 7b separately depicts a perspective depiction of the one-part connecting element 24 of the plug connection arrangement 1 according to the fifth exemplary embodiment from Figure 7a.

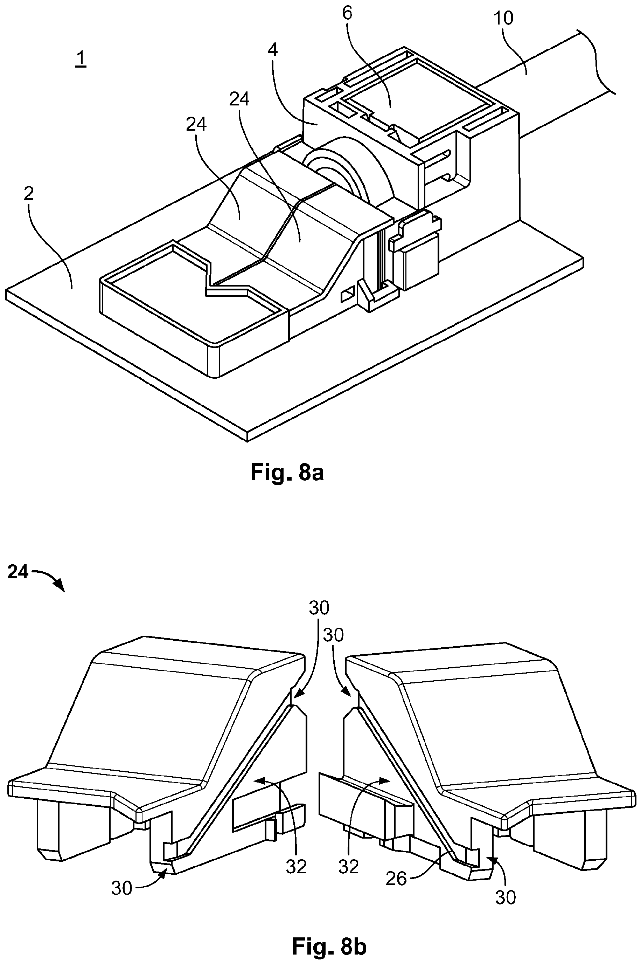

Figure 8a shows a perspective depiction of a plug connection arrangement 1 according to a sixth exemplary embodiment not covered by the claims. In contrast to the preceding exemplary embodiments of the plug connection arrangement 1, the housing 4 has an intermediate space between the dielectric waveguide 10 and the radiation source 16. In the intermediate space, a two-part connecting element 24 is connected to the housing in a form-fitting manner. Here, the two-part connecting element 24, similarly to a one-part connecting element 24, electromagnetically couples the radiation source 16 to the dielectric waveguide 10.

Figure 8b represents a perspective depiction of the multi-part connecting element 24 of the plug connection arrangement 1 according to the sixth exemplary embodiment from Figure 8a. The construction of the connecting element 24 is illustrated. Each half of the connecting element 24 has a cavity which defines the inner volume 26 of the connecting element 24. In this case, the cavity is coated with a metal and thus forms a metallic waveguide. The two parts of the connecting element 24 can be connected to one another in a form-fitting manner and can be inserted into the housing 4 together as a unit.

The inner volume 26 is filled with air, according to the exemplary embodiment.

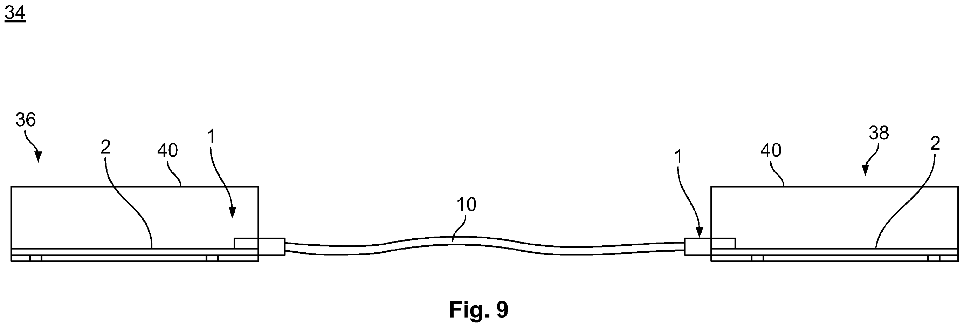

Figure 9 depicts a schematic depiction of a system 34 for transmitting data according to a first exemplary embodiment. The system 34 has a first controller 36 and a second controller 38. Each controller 36, 38 has one plug connection arrangement 1 each arranged in a controller housing 40. In this case, the plug connection arrangements 1 of the controllers 34, 36 are arranged such that they are each arranged on the rims of the printed circuit boards 2 and project out of the controller housings 40 at least in sections. As a result of this, the plug connection arrangements 1 do not have to be electromagnetically coupled into the controllers 36, 38 via further dielectric waveguides 10 and couplings. The two controllers 36, 38 are electromagnetically coupled to one another via an externally arranged dielectric waveguide 10 and can exchange information with one another with the help of the electromagnetic radiation.

### List of reference numbers

- 1: Plug connection arrangement
- 2: Printed circuit board
- 4: Housing
- 6: Receiving unit
- 8: Cylindrical opening of the receiving unit
- 10: Dielectric waveguide
- 12: End-sleeve
- 14: Circumferential recess
- 16: At least one radiation source
- 18: Actuator of the radiation source
- 20: Bond wire
- 22: Extension section of the waveguide
- 24: Connecting element
- 26: Inner volume
- 28: Metallised lateral surface
- 30: End region of the connecting element
- 32: Central region
- 34: System
- 36: First controller
- 38: Second controller
- 40: Controller housing

- x: Width of the central region
- y: Height of the central region
- dy: Height offset

## Claims

1. A plug connection arrangement (1) for mechanically and electromagnetically coupling at least one radiation source (16) to a dielectric waveguide (10),
having a printed circuit board (2),
having at least one housing (4) which is mounted on the printed circuit board (2),
having the at least one radiation source (16) for generating electromagnetic waves and
having the dielectric waveguide (10),
wherein the at least one radiation source (16) is enclosed, at least in sections, by the at least one housing (4) in a mounted state on the printed circuit board (2),
the plug connection arrangement (1) further has at least one receiving unit (6) for receiving and aligning the dielectric waveguide (10) which is connected tc the housing (4) and
wherein the dielectric waveguide (10), received by the at least one receiving unit (6), in the received state, is electromagnetically coupled to the at least one radiation source (16), directly or through a material of the housing (4),
**characterized in that** the plug connection arrangement has an actuator (18) of the at least one radiation source (16) arranged in the housing (4),
wherein the housing (4) is mounted on an edge of the printed circuit board (2) and projects beyond the edge of the printed circuit board (2).

2. The plug connection arrangement according to Claim 1, wherein the dielectric waveguide (10), when received by the at least one receiving unit (6), is aligned parallel to a planar elongation of the printed circuit board (2).

3. The plug connection arrangement according to any one of Claims 1 to 2, comprising at least one connecting element (24), wherein at least one connecting element (24) is arranged between the at least one radiation source (16) and the dielectric waveguide (10) to electromagnetically couple the at least one radiation source (16) to the dielectric waveguide (10).

4. The plug connection arrangement according to Claim 3, wherein the connecting element (24) is formed to be tubular, has an air-filled or plastics-filled inner volume and has a wall (28) made of metal or made of a metal coating.

5. The plug connection arrangement according to Claim 3 or 4, wherein the connecting element (24) has a rectangular cross-section and has an air-filled or plastics-filled inner volume (26) .

6. The plug connection arrangement according to any one of Claims 3 to 5, wherein the connecting element (24) has, at each end, a region (30) with a conically expanded cross-section.

7. The plug connection arrangement according to any one of Claims 3 to 6, wherein the connecting element (24) has a central region (32) between the end regions (30), wherein a rectangular cross-section of the central region (32) has at least a height (y) of a half propagation wavelength of the electromagnetic radiation and a smaller width (x) than the height (y).

8. The plug connection arrangement according to any one of Claims 3 to 7, wherein the connecting element (24) is designed to be straight or bent.

9. The plug connection arrangement according to any one of Claims 3 to 8, wherein the connecting element (24) is designed in one part or in multiple parts and is inserted into the housing (4) in a form-fitting or firmly-bonded manner.

10. A system (34) for transmitting data by electromagnetic radiation between a first controller (36) and a second controller (38), wherein each controller (36, 38) has a controller housing (40) with a plug connection arrangement (1) according to any one of Claims 1 to 9 and are electromagnetically connected to one another via the dielectric waveguide (10) of the plug connection arrangement (1) of the first controller (36) and the second controller (38) which is arranged outside the controller housing (40).

## Patentansprüche

1. Steckverbindungsanordnung (1) für eine mechanische und elektromagnetische Kopplung wenigstens einer Strahlungsquelle (16) mit einem dielektrischen Wellenleiter (10),
die eine Leiterplatine (2) hat,
die wenigstens ein Gehäuse (4) hat, das an der Leiterplatine (2) montiert ist,
die die wenigstens eine Strahlungsquelle (16) zum Erzeugen von elektromagnetischen Wellen hat, und
die den dielektrischen Wellenleiter (10) hat,
wobei die wenigstens eine Strahlungsquelle (16) in einem montierten Zustand auf der Leiterplatine (2) wenigstens in Teilstücken durch das wenigstens eine Gehäuse (4) umschlossen ist,
wobei die Steckverbindungsanordnung (1) ferner wenigstens eine Aufnahmeeinheit (6) zum Aufnehmen und Ausrichten des dielektrischen Wellenleiters (10) hat, die mit dem Gehäuse (4) verbunden ist, und
wobei der dielektrische Wellenleiter (10), der durch die wenigstens eine Aufnahmeeinheit (6) aufgenommen ist, im aufgenommenen Zustand mit der wenigstens einen Strahlungsquelle (16) direkt oder durch ein Material des Gehäuses (4) elektromagnetisch gekoppelt ist,
**dadurch gekennzeichnet, dass** die Steckverbindungsanordnung einen Aktuator (18) der wenigstens einen Strahlungsquelle (16) hat, der im Gehäuse (4) angeordnet ist,
wobei das Gehäuse (4) an einer Kante der Leiterplatine (2) montiert ist und über die Kante der Leiterplatine (2) vorsteht.

2. Steckverbindungsanordnung nach Anspruch 1, wobei der dielektrische Wellenleiter (10), wenn er durch die wenigstens eine Aufnahmeeinheit (6) aufgenommen ist, parallel zu einer planaren Verlängerung der Leiterplatine (2) ausgerichtet ist.

3. Steckverbindungsanordnung nach einem der Ansprüche 1 bis 2, die wenigstens ein Verbindungselement (24) umfasst, wobei das wenigstens eine Verbindungselement (24) zwischen der wenigstens einen Strahlungsquelle (16) und dem dielektrischen Wellenleiter (10) angeordnet ist, um die wenigstens eine Strahlungsquelle (16) mit dem dielektrischen Wellenleiter (10) elektromagnetisch zu koppeln.

4. Steckverbindungsanordnung nach Anspruch 3, wobei das Verbindungselement (24) so ausgebildet ist, dass es rohrförmig ist, ein luftgefülltes oder mit Kunststoff gefülltes Innenvolumen hat und eine Wand (28) hat, die aus Metall gefertigt ist oder aus einer Metallbeschichtung gefertigt ist.

5. Steckverbindungsanordnung nach Anspruch 3 oder 4, wobei das Verbindungselement (24) einen rechteckigen Querschnitt hat und ein luftgefülltes oder mit Kunststoff gefülltes Innenvolumen (26) hat.

6. Steckverbindungsanordnung nach einem der Ansprüche 3 bis 5, wobei das Verbindungselement (24) an jedem Ende einen Bereich (30) mit einem konisch erweiterten Querschnitt hat.

7. Steckverbindungsanordnung nach einem der Ansprüche 3 bis 6, wobei das Verbindungselement (24) einen zentralen Bereich (32) zwischen den Endbereichen (30) hat, wobei ein rechteckiger Querschnitt des zentralen Bereichs (32) wenigstens eine Höhe (y) einer halben Ausbreitungswellenlänge der elektromagnetischen Strahlung und eine kleinere Breite (x) als die Höhe (y) hat.

8. Steckverbindungsanordnung nach einem der Ansprüche 3 bis 7, wobei das Verbindungselement (24) so ausgelegt ist, dass es gerade oder gebogen ist.

9. Steckverbindungsanordnung nach einem der Ansprüche 3 bis 8, wobei das Verbindungselement (24) einteilig oder mehrteilig ausgelegt ist und in das Gehäuse (4) formschlüssig oder fest verklebt eingesetzt ist.

10. System (34) zum Übertragen von Daten durch elektromagnetische Strahlung zwischen einer ersten Steuerung (36) und einer zweiten Steuerung (38), wobei beide Steuerungen (36, 38) jeweils ein Steuerungsgehäuse (40) mit einer Steckverbindungsanordnung (1) nach einem der Ansprüche 1 bis 9 haben und über den dielektrischen Wellenleiter (10) der Steckverbindungsanordnung (1) der ersten Steuerung (36) und der zweiten Steuerung (38), der außerhalb des Steuerungsgehäuses (40) angeordnet ist, elektromagnetisch miteinander verbunden sind.

## Revendications

1. Agencement de connexion enfichable (1) pour coupler mécaniquement et électromagnétiquement au moins une source de rayonnement (16) à un guide d'ondes diélectrique (10),
pourvu d'une carte de circuit imprimé (2),
pourvu d'au moins un boîtier (4) qui est monté sur la carte de circuit imprimé (2),
pourvu de l'au moins une source de rayonnement (16) pour générer des ondes électromagnétiques et
pourvu du guide d'ondes diélectrique (10),
l'au moins une source de rayonnement (16) étant enfermée, au moins en partie, par l'au moins un boîtier (4) dans un état monté sur la carte de circuit imprimé (2),
l'agencement de connexion enfichable (1) étant en outre pourvu d'au moins une unité réceptrice (6) pour recevoir et aligner le guide d'ondes diélectrique (10) qui est connecté au boîtier (4) et
le guide d'ondes diélectrique (10), reçu par l'au moins une unité réceptrice (6), dans l'état reçu, étant couplé électromagnétiquement à l'au moins une source de rayonnement (16), directement ou par le biais d'un matériau du boîtier (4),
l'agencement de connexion enfichable étant **caractérisé en ce qu'**il est pourvu d'un actionneur (18) de l'au moins une source de rayonnement (16) agencé dans le boîtier (4),
le boîtier (4) étant monté sur un bord de la carte de circuit imprimé (2) et faisant saillie au-delà du bord de la carte de circuit imprimé (2).

2. Agencement de connexion enfichable selon la revendication 1, dans lequel le guide d'ondes diélectrique (10), lorsqu'il est reçu par l'au moins une unité réceptrice (6), est aligné parallèlement à une étendue plane de la carte de circuit imprimé (2).

3. Agencement de connexion enfichable selon l'une quelconque des revendications 1 à 2, comprenant au moins un élément connecteur (24), au moins un élément connecteur (24) étant agencé entre l'au moins une source de rayonnement (16) et le guide d'ondes diélectrique (10) pour coupler électromagnétiquement l'au moins une source de rayonnement (16) au guide d'ondes diélectrique (10).

4. Agencement de connexion enfichable selon la revendication 3, dans lequel l'élément connecteur (24) est doté d'une forme tubulaire, est pourvu d'un volume intérieur rempli d'air ou rempli de plastique et est pourvu d'une paroi (28) composée de métal ou composée d'un revêtement métallique.

5. Agencement de connexion enfichable selon la revendication 3 ou 4, dans lequel l'élément connecteur (24) est pourvu d'une section transversale rectangulaire et est pourvu d'un volume intérieur (26) rempli d'air ou rempli de plastique.

6. Agencement de connexion enfichable selon l'une quelconque des revendications 3 à 5, dans lequel l'élément connecteur (24) est pourvu, à chaque extrémité, d'une région (30) dotée d'une section transversale s'élargissant coniquement.

7. Agencement de connexion enfichable selon l'une quelconque des revendications 3 à 6, dans lequel l'élément connecteur (24) est pourvu d'une région centrale (32) entre les régions d'extrémité (30), une section transversale rectangulaire de la région centrale (32) étant pourvue au moins d'une hauteur (y) d'une demi-longueur d'onde de propagation du rayonnement électromagnétique et d'une largeur (x) inférieure à la hauteur (y).

8. Agencement de connexion enfichable selon l'une quelconque des revendications 3 à 7, dans lequel l'élément connecteur (24) est conçu droit ou recourbé.

9. Agencement de connexion enfichable selon l'une quelconque des revendications 3 à 8, dans lequel l'élément connecteur (24) est conçu en une seule partie ou en plusieurs parties et est inséré dans le boîtier (4) par coopération de formes ou par collage solide.

10. Système (34) de transmission de données par rayonnement électromagnétique entre un premier contrôleur (36) et un deuxième contrôleur (38), chaque contrôleur (36, 38) étant pourvu d'un boîtier (40) de contrôleur doté d'un agencement de connexion enfichable (1) selon l'une quelconque des revendications 1 à 9 et étant connecté électromagnétiquement à l'autre par le biais du guide d'ondes diélectrique (10) de l'agencement de connexion enfichable (1) du premier contrôleur (36) et du deuxième contrôleur (38) qui est agencé en dehors du boîtier (40) de contrôleur.
